# EUROPEAN PATENT APPLICATION

(11) **EP 2 876 693 A1**
(43) Date of publication of application: **27.05.2015**
(21) Application number: 14193935.5
(22) Date of filing: 19.11.2014
(51) Int. Cl.: H01L 31/0468, H01L 31/0749

(54) **Solar cell**

(30) Priority: 20.11.2013 KR 20130141612
(71) Applicant: Samsung SDI Co., Ltd., Yongin-si, Gyeonggi-do (KR)
(72) Inventor: Nam, Yuk-Hyun, Gyeonggi-do (KR)
(74) Representative: Taor, Simon Edward William

(57) **Abstract**

A solar cell array includes: a substrate; a plurality of first electrodes on the substrate; a photoactive layer on the first electrodes, and including a transmission groove exposing the substrate and a through-groove exposing a neighboring first electrode of the plurality of first electrodes; a second electrode on the photoactive layer and electrically connected with the neighboring first electrode through the through-groove, and the transmission groove and the through-groove are parallel with each other, and the photoactive layer is between the transmission groove and the through-groove.

## Description

Aspects of embodiments of the present invention relate to a solar cell, and to a solar cell array including a CIGS semiconductor.

As a photovoltaic element that converts solar energy to electrical energy, a solar cell array is gaining much interest as unlimited and non-polluting next generation energy.

A solar cell array includes a p-type semiconductor and an n-type semiconductor, and when solar energy is absorbed at a photoactive layer, an electron-hole pair (EHP) is generated in the semiconductor, wherein the generated electron and hole move to the n-type semiconductor and the p-type semiconductor, respectively, and are collected by electrodes, and can then be used as electrical energy.

As the photoactive layer, a compound semiconductor including group I-III-VI elements may be used. The compound semiconductor may realize a high efficiency solar cell array with a high light absorption coefficient and high optical stability.

However, when a solar cell array using a compound semiconductor that includes the group I-III-VI elements is formed, a metal made of an opaque material is generally used as an electrode, unlike an amorphous solar cell array, and therefore it is impossible to use a separation line as an opening as in the amorphous solar cell array.

Therefore, the solar cell array including the compound semiconductor that includes the group I-III-VI elements needs an additional process for forming an opening after forming an electrode as a double-layered electrode of an opaque material and a transparent conductive material.

In this case, ITO, IZO, and the like are mainly used as the transparent conductive material, and expensive vacuum equipment is needed to form a thin film with such a material. Further, the transparent conductive material functions as a barrier layer that interrupts dispersion of sodium of the substrate, thereby deteriorating efficiency of the solar cell array.

The above information disclosed in this Background section is only for enhancement of understanding of the background of the described technology, and therefore it may contain information that does not form the prior art that is already known in this country to a person of ordinary skill in the art.

According to an aspect of embodiments of the present invention, a CIGS type solar cell array has improved efficiency even though an opaque metal is included.

According to an exemplary embodiment of the present invention, a solar cell array includes: a substrate; a plurality of first electrodes on the substrate; a photoactive layer on the first electrodes, and including a transmission groove exposing the substrate and a through-groove exposing a neighboring first electrode of the plurality of first electrodes; a second electrode on the photoactive layer and electrically connected with the neighboring first electrode through the through-groove, and the transmission groove and the through-groove are parallel with each other, and the photoactive layer is between the transmission groove and the through-groove.

The first electrodes may include an opaque metal, and the opaque metal may include molybdenum.

A width of the transmission groove may be greater than 150 µm, and a width of the through-groove may be 20 µm to 100 µm.

The second electrode may include a transparent conductive material, and the transparent conductive material may include at least one of IZO, ITO, and ZnO.

The photoactive layer may include a CIGS-based material.

The solar cell array may further include a buffer layer between the photoactive layer and the second electrode.

According to another exemplary embodiment of the present invention, a solar cell array includes: a substrate; a plurality of first electrodes on the substrate; a photoactive layer on the first electrodes, and including a transmission groove exposing the substrate and a through-groove exposing a first electrode of the plurality of first electrodes; and a second electrode on the photoactive layer and including a first separation groove exposing the first electrode, and the transmission groove and the through-groove are parallel with each other, and the photoactive layer is between the transmission groove and the through-groove.

The first electrode may further include a second separation groove, and the transmission groove may be between the first separation groove and the second separation groove.

The solar cell array may further include a connection portion filling the transmission groove and including a same material as the second electrode.

The transmission groove, the through-groove, the first separation groove, and the second separation groove may be formed linearly parallel with each other.

A width of the transmission groove may be greater than 150 µm, and a width of each of the through-groove, the first separation groove, and the second separation groove may be 20 µm to 100 µm.

The first electrodes may include an opaque metal, and the second electrode may include a transparent conductive material.

The opaque metal may include molybdenum, and the transparent conductive material may include at least one of IZO, ITO, and ZnO.

The photoactive layer may include a CIGS-based material.

The solar cell array may further include a buffer layer between the photoactive layer and the second electrode. The second electrode may further include a second separation groove exposing the buffer layer, and the transmission groove may be between the first separation groove and the second separation groove.

According to an aspect of the invention, there is provided a solar cell array as set out in claim 1, and a solar cell array as set out in claim 6. Preferred features are set out in claims 2 to 5 and 7 to 15.

According to an aspect of embodiments of the present invention, efficiency of the solar cell array is increased without additionally forming a transparent conductive material, even though an opaque metal is used.

The above and/or other aspects will become apparent and more readily appreciated from the following description of some exemplary embodiments of the present invention, taken in conjunction with the accompanying drawings.
FIG. 1 is a schematic top view of a solar cell array according to an exemplary embodiment of the present invention.
FIG. 2 is a cross-sectional view of the solar cell array of FIG. 1, taken along the line II-II.
FIG. 3 is a schematic top view of a solar cell array according to another exemplary embodiment of the present invention.
FIG. 4 is a cross-sectional view of the solar cell array of FIG. 3, taken along the line IV-IV.

The present invention is described more fully hereinafter with reference to the accompanying drawings, in which some exemplary embodiments of the present invention are shown. As those skilled in the art would realize, the described embodiments may be modified in various different ways, all without departing from the scope of the present invention. Accordingly, the drawings and description are to be regarded as illustrative in nature and not restrictive.

In the drawings, the thicknesses of layers, films, panels, regions, etc., may be exaggerated for clarity. Like reference numerals designate like elements throughout. It is to be understood that when an element such as a layer, film, region, or substrate is referred to as being "on" another element, it can be directly on the other element, or one or more intervening elements may also be present. In contrast, when an element is referred to as being "directly on" another element, there are no intervening elements present.

A solar cell array according to one or more exemplary embodiments of the present invention is described in further detail below with reference to the accompanying drawings.

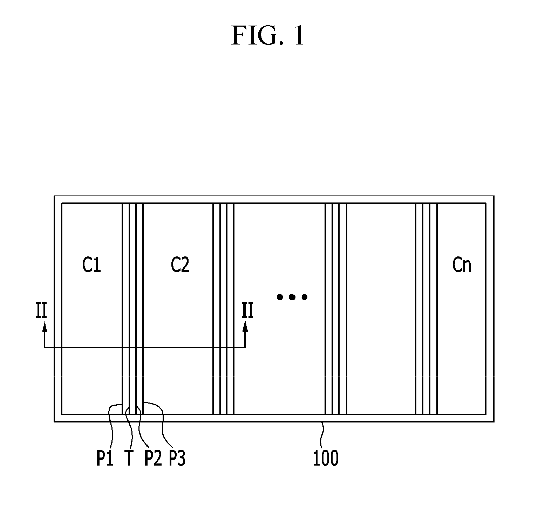

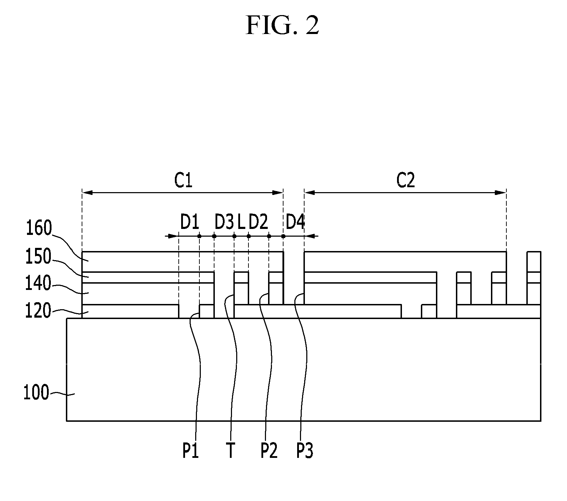

FIG. 1 is a schematic top view of a solar cell array according to an exemplary embodiment of the present invention, and FIG. 2 is a cross-sectional view of the solar cell array of FIG. 2, taken along the line II-II.

As shown in FIG. 1 and FIG. 2, a solar cell array according to an exemplary embodiment of the present invention includes a plurality of solar cells C1, C2, to Cn formed on a substrate 100.

Each solar cell includes a first electrode 120, a photoactive layer 140 formed on the first electrode 120, a buffer layer 150 formed on the photoactive layer 140, and a second electrode 160 formed on the buffer layer 150, and neighboring cells are electrically connected with each other.

Referring to FIG. 2, an interlayer structure of the solar cell array of FIG. 1 is described in further detail below.

As shown in FIG. 2, a plurality of first electrodes 120 is formed on the substrate 100. In one embodiment, the first electrodes 120 are separated or spaced apart from each other with a constant gap P1 therebetween. In one embodiment, a width D1 of the gap P1 may be 20 µm to 100 µm.

The substrate 100 may be made of an insulating transparent material, such as soda-lime glass, for example.

The first electrode 120 may be made of a metal having an excellent heat resistive characteristic, an excellent electrical contact characteristic with respect to a material that forms the photoactive layer 140, excellent electric conductivity, and excellent interface adherence with the substrate 100. In one embodiment, for example, the first electrode 120 may be made of molybdenum (Mo).

The photoactive layer 140 and the buffer layer 150 are formed on the first electrode 120. The photoactive layer 140 fills the gap P1 between neighboring first electrodes 120.

As a p-type CIS semiconductor, the photoactive layer 140 may include selenium (Se) or sulfur (S). For example, the photoactive layer 140 may include Cu(In1-x,Gax)(Se1-x,Sx) as a group I-III-VI-based semiconductor compound, and may be a compound semiconductor having a composition of 0≤X≤1. The photoactive layer 140 may have a single phase of which a composition in the compound semiconductor is substantially uniform. For example, the photoactive layer 140 may be CuInSe2, CuInS2, Cu(In,Ga)Se2, (Ag,Cu)(In,Ga)Se2, (Ag,Cu)(In,Ga)(Se,S)2, Cu(In,Ga)(Se,S)2, or Cu(In,Ga)S2. In addition, the photoactive layer 140 may include sodium (Na), which is diffused from the substrate 100.

The buffer layer 150 reduces an energy gap difference between the photoactive layer 140 and the second electrode 160. The buffer layer 150 may be made of an n-type semiconductor material having high light transmittance, such as CdS, ZnS, or InS, for example.

The buffer layer 150 and the photoactive layer 140 include a transmission groove T exposing the substrate 100 and a through-groove P2 exposing the first electrode 120. The through-groove P2 exposes the first electrode 120 of neighboring solar cells. In one embodiment, the through-groove P2 and the transmission groove T are linearly parallel with each other. In one embodiment, a width D3 of the transmission groove T may be greater than 150 µm, and a width D2 of the through-groove P2 may be 20 µm to 100 µm. In addition, a gap L between the through-groove P2 and the transmission groove T may be 100 µm to 300 µm.

The second electrode 160 is formed on the buffer layer 150.

The second electrode 160 may be made of a material having high light transmittance and excellent electrical conductivity, and may be formed in a single layer or a multilayer of ITO/IZO/ZnO, for example. The light transmittance may be greater than about 80 %. In one embodiment, the ZnO layer has a low resistance value by being doped with aluminum (Al) or boron (B).

When the second electrode 160 is formed as a multilayer, the ITO layer having an excellent electro-optical characteristic may be layered on the ZnO layer, or an n-type ZnO layer having a low resistance value may be layered on an i-type undoped ZnO layer.

The second electrode 160 is an n-type semiconductor, and forms a pn junction with the photoactive layer 140, which is a p-type semiconductor.

The second electrode 160, in one embodiment, includes a separation groove P3 exposing the first electrode 120. The separation groove P3 exposes the first electrode 120 of neighboring solar cells, and a width D4 of the separation groove P3 may be 20 µm to 100 µm.

In one embodiment, as shown in FIG. 2, the through-groove P2 is provided between the transmission groove T and the separation groove P3, but, in another embodiment, the transmission groove T may be provided between the through-groove P2 and the separation groove P3.

Since light can be transmitted to the photoactive layer 140 through the transmission groove T according to the above-described exemplary embodiment of the present invention, the amount of light transmitted to the photoactive layer can be increased without forming the electrode with a transparent conductive material that affects the amount of dispersion of sodium of the substrate, thereby increasing efficiency of the solar cell array.

A solar cell array according to another exemplary embodiment of the present invention is described below.

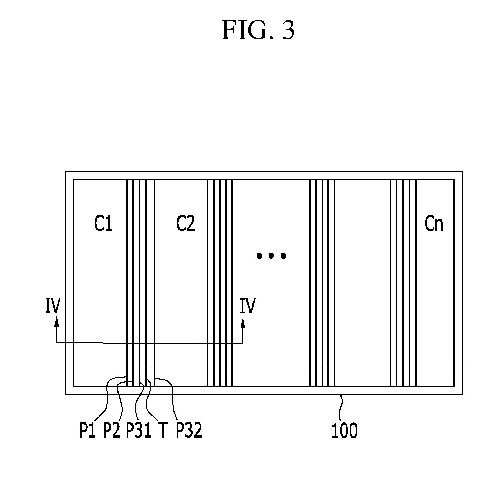

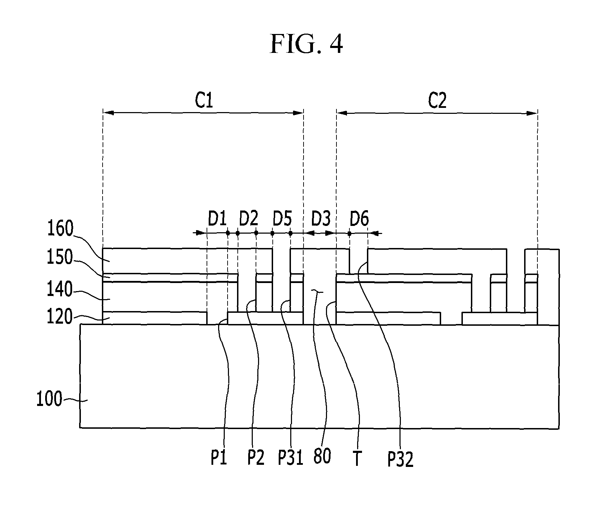

FIG. 3 is a schematic top view of a solar cell array according to another exemplary embodiment of the present invention, and FIG. 4 is a cross-sectional view of the solar cell array of FIG. 3, taken along the line IV-IV.

Most of the layering structure of the present exemplary embodiment is the same as that of the embodiment described above with respect to FIGS. 1 and 2, and therefore only the different portion will be described in detail.

The solar cell array of FIG. 3 and FIG. 4 includes solar cells C₁, C₂ to Cn formed on a substrate 100.

Each solar cell includes a first electrode 120, a photoactive layer 140 formed on the first electrode 120, a buffer layer 150 formed on the photoactive layer 140, and a second electrode 160 formed on the buffer layer 150, and neighboring cells are electrically connected with each other.

In one embodiment, the first electrodes 120 of the solar cells are separated or spaced apart from each other with a constant gap P1 therebetween, and the buffer layer 150 and the photoactive layer 140 each includes a through-groove P2 exposing the first electrode 120 and a transmission groove T exposing the substrate 100.

The solar cell array of FIG. 3 and FIG. 4 includes a first separation groove P31 and a second separation groove P32.

The first separation groove P31 exposes the first electrode 120 through the second electrode 160, the buffer layer 150, and the photoactive layer 140, and the second separation groove P32 exposes the buffer layer 150 through the second electrode 160. Respective widths D5 and D6 of the first separation groove P31 and the second separation groove P32 may be 20 µm to 100 µm.

In addition, a connection portion 80 is further formed in the transmission groove T. The connection portion 80 fills the transmission groove T and overlaps the photoactive layer 140 and the buffer layer 150 between the first separation groove P31 and the transmission groove T and between the second separation groove P32 and the transmission groove T. The connection portion 80 may be made of a same material as the second electrode 160.

As shown in FIG. 3 and FIG. 4, when the transmission groove T is provided between the first separation groove P31 and the second separation groove P32, solar cells disposed at both sides of the transmission groove T may be electrically separated from each other. Therefore, the connection portion 80 is provided to electrically connect the two neighboring cells.

As discussed above, embodiments of the invention can provide a solar cell array comprising: a substrate; a plurality of first electrodes on the substrate; a plurality of photoactive layers, wherein each photoactive layer is formed on a said first electrode, and wherein each photoactive layer includes a transmission groove exposing the substrate and a through-groove exposing a neighboring first electrode of the plurality of first electrodes; a plurality of second electrodes, wherein each second electrode is formed on a said photoactive layer and is arranged to electrically connect with a neighboring first electrode through a said through-groove, wherein the transmission grooves and the through-grooves are parallel with each other, and a portion of a said photoactive layer is between a said transmission groove and a said through-groove.

Embodiments of the invention can also provide solar cell array comprising: a substrate; a plurality of first electrodes on the substrate; a plurality of photoactive layers, wherein each photoactive layer is formed on a said first electrode, and wherein each photoactive layer includes a transmission groove exposing the substrate and a through-groove exposing a first electrode of the plurality of first electrodes; and a plurality of second electrodes, wherein each second electrode is formed on a said photoactive layer and includes a first separation groove exposing a said first electrode, wherein the transmission grooves and the through-grooves are parallel with each other, and a portion of a said photoactive layer is between a said transmission groove and a said through-groove.

While this disclosure has been described in connection with what are presently considered to be some practical exemplary embodiments, it is to be understood that the present invention is not limited to the disclosed exemplary embodiments, but, on the contrary, is intended to cover various modifications and equivalent arrangements included within the scope of the appended claims, and equivalents thereof.

## Claims

1. A solar cell array comprising:
a substrate;
a plurality of first electrodes on the substrate;
a plurality of photoactive layers, wherein each photoactive layer is formed on a said first electrode, and wherein each photoactive layer includes a transmission groove exposing the substrate and a through-groove exposing a neighboring first electrode of the plurality of first electrodes;
a plurality of second electrodes, wherein each second electrode is formed on a said photoactive layer and is arranged to electrically connect with a neighboring first electrode through a said through-groove,
wherein the transmission grooves and the through-grooves are parallel with each other, and a portion of a said photoactive layer is between a said transmission groove and a said through-groove.

2. The solar cell array of claim 1, wherein a width of the transmission groove is greater than 150 µm.

3. The solar cell array of claim 2, wherein a width of the through-groove is 20 µm to 100 µm.

4. The solar cell of any one of claims 1 to 3, wherein each second electrode comprises a separation groove exposing a said first electrode, and
each respective through-groove is between a said transmission groove and a said separation groove.

5. The solar cell array of any one of claims 1 to 4, further comprising a plurality of buffer layers, wherein each buffer layer is between a said photoactive layer and a said second electrode.

6. A solar cell array comprising:
a substrate;
a plurality of first electrodes on the substrate;
a plurality of photoactive layers, wherein each photoactive layer is formed on a said first electrode, and wherein each photoactive layer includes a transmission groove exposing the substrate and a through-groove exposing a first electrode of the plurality of first electrodes; and
a plurality of second electrodes, wherein each second electrode is formed on a said photoactive layer and includes a first separation groove exposing a said first electrode,
wherein the transmission grooves and the through-grooves are parallel with each other, and a portion of a said photoactive layer is between a said transmission groove and a said through-groove.

7. The solar cell array of claim 6,
wherein each second electrode further includes a second separation groove, and
wherein each respective transmission groove is between a said first separation groove and a said second separation groove.

8. The solar cell array of claim 6, further comprising a plurality of buffer layers, wherein each buffer layer is between a said photoactive layer and a said second electrode;
optionally wherein each second electrode further includes a second separation groove exposing a said buffer layer, and wherein each respective transmission grooves is between a said first separation groove and a said second separation groove.

9. The solar cell array of any one of claims 7 or 8, further comprising a plurality of connection portions, wherein each connection portion is arranged to fill a said transmission groove and comprises a same material as the second electrodes.

10. The solar cell array of any one of claims 7 to 9, wherein the transmission grooves, the through-grooves, the first separation grooves, and the second separation grooves are formed linearly parallel with each other.

11. The solar cell array of any one of claims 6 to 10, wherein a width of each transmission groove is greater than 150 µm.

12. The solar cell array of claim 11, wherein a width of each of the through-grooves, the first separation grooves, and the second separation grooves is 20 µm to 100 µm.

13. The solar cell array of any one of claims 1 to 12, wherein the second electrodes comprise a transparent conductive material, optionally wherein the transparent conductive material comprises at least one of IZO, ITO, and ZnO.

14. The solar cell array of any one of claims 1 to 13, wherein the first electrodes comprise an opaque metal, optionally wherein the opaque metal comprises molybdenum.

15. The solar cell array of any one of claims 1 to 14, wherein the photoactive layer comprises a CIGS-based material.
